# EUROPEAN PATENT APPLICATION

(11) **EP 4 726 767 A2**
(43) Date of publication of application: **15.04.2026**
(21) Application number: 25201458.4
(22) Date of filing: 10.09.2025
(51) Int. Cl.: H01J 37/20

(54) **SAMPLE HOLDER, SAMPLE HOLDER SET, SAMPLE MILLING EQUIPMENT, AND TIGHTENING TOOL**

(30) Priority: 18.09.2024 JP 2024161107
(71) Applicant: JEOL Ltd., Tokyo 196-8558 (JP)
(72) Inventor: KOIKE, Rentaro, Tokyo 196-8558 (JP); FUKUDA, Tomohisa, Tokyo 196-8558 (JP); KIMURA, Tatsuhito, Tokyo 196-8558 (JP)
(74) Representative: Boult Wade Tennant LLP

(57) **Abstract**

There is provided a sample holder capable of restricting the positional deviation of a sample. The sample holder (100) is for use with sample milling equipment that mills the sample (2) by irradiating it with an ion beam (IB). The sample holder (100) includes a holder base (10), a sample holding portion (20) for holding the sample (2), and a positional securing portion (40) for securing the sample holding portion (20) in position. The positional securing portion (40) includes a shaft (42) connected to the sample holding portion (20), a first supportive member (44) providing rotatable support of the shaft (42), and a second supportive member (46) supporting the first supportive member (44) such that it can move along an axis perpendicular to the axis of the shaft (42). When the second supportive member (46) is rotated, the second supportive member (46) moves along the axis of the shaft (42), thus tightening together the sample holding portion (20) and the holder base (10) while rotation of the first supportive member (44) concomitant with the rotation of the second supportive member (46) is restricted.

## Description

### BACKGROUND OF THE INVENTION

### 1. Field of the Invention

The present invention relates to a sample holder for use in sample milling equipment utilizing ion beam irradiation and also to a sample holder set comprising the first-mentioned sample holder. In addition, the present invention relates to such sample milling equipment and to a tightening tool for use therein.

### 2. Description of the Related Art

Cross-Section Polisher (trademark registered) is known as sample milling equipment for milling a sample with an ion beam. With sample milling equipment such as Cross-Section Polisher, a cross section across a certain position can be prepared, for example, either in a through-hole present in a printed circuit board or in a semiconductor chip having a fine circuit pattern.

For example, Patent document 1 discloses a sample holder system equipped both with a sample holder for holding a sample and with a sample adjusting unit for making a positional alignment between the sample and a shielding plate, the adjusting unit being detachably attached to the sample holder. In this disclosed sample holder system, the sample and the shielding plate can be positionally aligned relative to each other using the sample adjusting unit and so the sample holder can be simplified in structure.

### Citation List

### Patent Documents

Patent document 1: JP-A-2019-3732

In the sample holder system set forth in Patent document 1, after the sample held on the sample holding portion is adjusted in position by the sample adjusting unit, the sample holding portion is fastened to the holder body by tightening set screws. With this sample holder, when the set screws are tightened, the sample holding portion will move concomitantly with the rotation of the set screws and may move out of position relative to the shielding plate.

### SUMMARY OF THE INVENTION

One aspect of the sample holder associated with the present invention is for use in sample milling equipment which mills a sample by irradiating it with an ion beam and comprises:
a holder base;
a sample holding portion for holding the sample; and
a positional securing portion for securing the sample holder portion in position.

The positional securing portion includes: a shaft connected to the sample holding portion and having an axis; a first supportive member providing rotatable support of the shaft; and a second supportive member supporting the first supportive member such that the first supportive member can move along an axis perpendicular to the axis of the shaft. When the second supportive member is rotated, it moves along the axis of the shaft, thus tightening together the sample holding portion and the holder base while rotation of the first supportive member concomitant with the rotation of the second supportive member is restricted.

In this sample holder, when the second supportive member is rotated to tighten the sample holding portion and the holder base together, the first supportive member does not rotate concomitantly with the rotation of the second supportive member. Therefore, in this sample holder, the positional deviation of the sample when the sample holding portion and the holder base are tightened together can be reduced.

One aspect of the sample holder set associated with the present invention comprises the sample holder described above and a tightening tool for tightening the second supportive member of the positional securing portion at less than a given torque value.

This sample holder set includes the above-described sample holder and, therefore, the positional deviation of the sample occurring when the sample holding portion and the holder base are tightened together can be reduced. Furthermore, this sample holder set includes the tightening tool for tightening the second supportive member at less than the given torque value. Consequently, when the second supportive member is tightened, less distortions are induced in the holder base, the sample holding portion, the shaft, the first supportive member, and the second supportive member. Hence, the positional deviation of the sample can be reduced.

One aspect of the sample milling equipment associated with the present invention includes the above-described sample holder.

One aspect of the tightening tool associated with the present invention is adapted to tighten a fastener member and includes: a shank member having a front end portion connected to the fastener member; a shank support member providing rotatable support of a rear end portion of the shank member; and a positioning member for placing the shank member in position. The rear end portion of the shank member is provided with a recessed portion. The positioning member includes: a ball-like portion fitted in the recessed portion; and a resilient member for pushing the ball-like portion against the recessed portion. When a torque greater than a given torque value is applied to the fastener member, the ball-like portion comes out of the recessed portion.

With this tightening tool, when a torque greater than the given torque value is applied to the fastener member, the ball-like portion comes out of the recessed portion and the tightening member bends. Therefore, this tightening tool can prevent application of a torque greater than the given torque value to the fastener member.

### BRIEF DESCRIPTION OF THE DRAWINGS

FIGS. 1 and 2 are schematic perspective views of a sample holder.
FIG. 3 is a schematic cross-sectional perspective view of the sample holder of FIGS. 1-2.
FIGS. 4 and 5 are schematic cross-sectional views of the sample holder of FIGS. 1-3.
FIG. 6 shows cross-sectional views illustrating the operation of a sample-securing portion.
FIGS. 7 and 8 are schematic cross-sectional views of the sample holder of FIGS. 1-5.
FIG. 9 is a schematic, exploded perspective view of a position securing portion.
FIGS. 10-13 are views illustrating the operation of the sample holder.
FIGS. 14-15 are schematic perspective views of a tightening tool.
FIGS. 16-17 are schematic cross-sectional views of the tightening tool.
FIGS. 18 and 19 are views illustrating a cover member.
FIG. 20 is a view illustrating one example of configuration of sample milling equipment.
FIG. 21 is a view illustrating the operation of a sample stage extracting mechanism.
FIGS. 22 and 23 are views illustrating a sample position adjusting jig.
FIG. 24 is a flowchart illustrating one example of a sample milling method using the sample milling equipment.
FIGS. 25 and 26 are views illustrating a modification of the tightening tool.

### DETAILED DESCRIPTION OF THE INVENTION

The preferred embodiments of the present invention are hereinafter described in detail with reference to the drawings. It is to be understood that the embodiments provided below do not unduly restrict the scope and content of the present invention delineated by the appended claims and that not all the configurations described below are essential constituent components of the invention.

### 1. Sample Holder

### 1.1. Configuration of Sample Holder

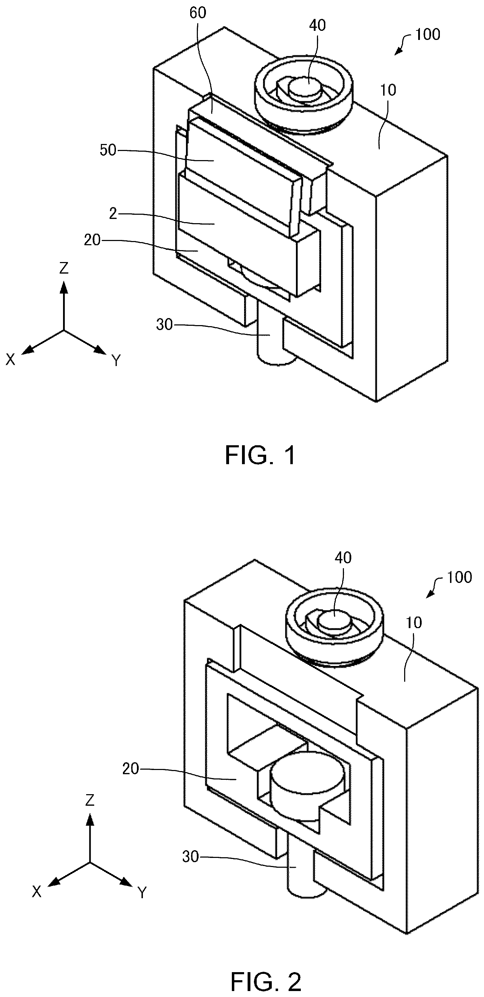

A sample holder associated with one embodiment of the present invention is first described by referring to FIGS. 1 and 2, which are schematic perspective views of this sample holder, 100. FIG. 1 shows a state in which a sample 2 and a shielding plate 50 have been attached to the sample holder 100, while FIG. 2 shows a state in which the sample 2 and the shielding plate 50 have been detached from the sample holder 100. X, Y, and Z axes are shown as three mutually orthogonal axes in these FIGS. 1 and 2.

The sample holder 100 is for use with sample milling equipment that mills the sample 2 by the use of an ion beam. As shown in FIGS. 1 and 2, the sample holder 100 includes a holder base 10, a sample holding portion 20, a sample securing portion 30, and a positional securing portion 40, as well as the shielding plate 50.

The holder base 10 is boxlike in form and provided with an opening in the +X direction, and has the positional securing portion 40 by means of which the sample holding portion 20 is secured to the holder base 10. The shielding plate 50 is mounted to the holder base 10 via a shielding plate holding member 60.

The sample holding portion 20 holds the sample 2. In the illustrated example, the sample holding portion 20 directly holds the sample 2. If the sample 2 is small in size, the sample holding portion 20 may hold the sample 2 along with a spacer member in a manner not illustrated. The sample holding portion 20 is boxlike in form and provided with an opening in the +X direction.

The sample securing portion 30 secures the sample 2 to the sample holding portion 20 by bringing the sample 2 into intimate contact with the sample holding portion 20.

The positional securing portion 40 positionally secures the sample holding portion 20. The sample holder 100 can be switched by the positional securing portion 40 between a state where the position of the sample holding portion 20 is fixed and a state where the sample holding portion 20 is movable.

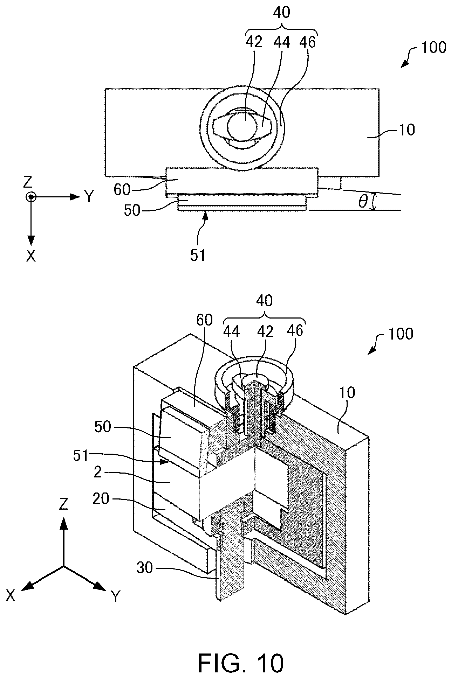

The shielding plate 50 shields a part of the sample 2 held to the sample holding portion 20. The shielding plate 50 is mounted to the holder base 10 via the shielding plate holding member 60. The shielding plate 50 is so arranged as to be in contact with the surface of the sample 2 that faces the +Z direction, i.e., the top surface of the sample 2. The shielding plate 50 has an edge 51 (see FIGS. 10-13), and the sample 2 is so arranged as to protrude from the edge 51.

### 1.2. Holder Base and Sample Holding Portion

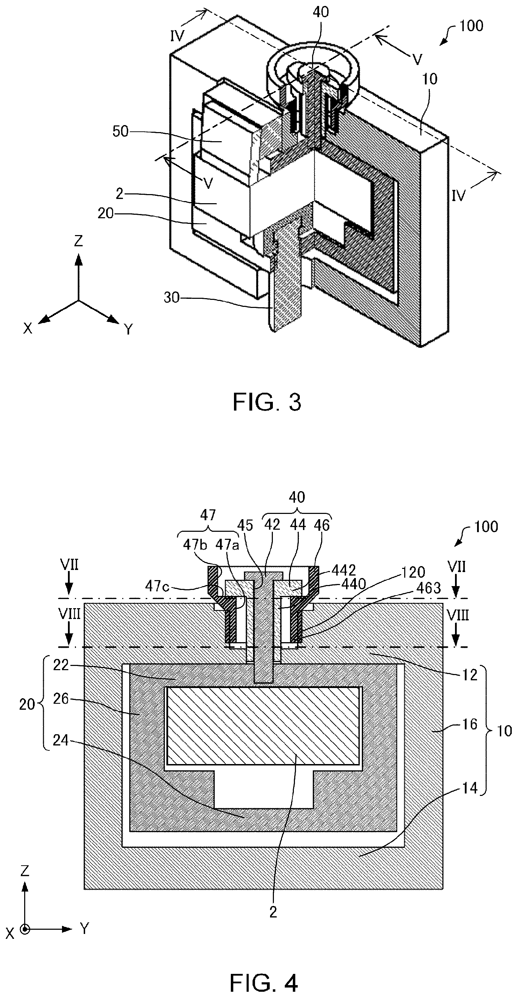

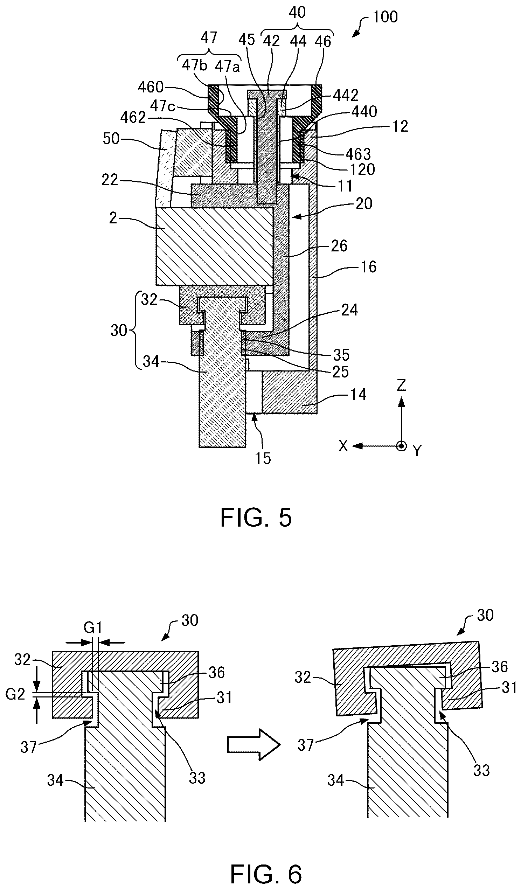

FIG. 3 is a schematic cross-sectional perspective view of the sample holder 100. FIGS. 4 and 5 are schematic cross-sectional views of the sample holder 100. FIG. 4 is a cross-sectional view taken on line IV-IV of FIG. 3. FIG. 5 is a cross-sectional view taken on line V-V of FIG. 3.

As shown in FIGS. 4 and 5, the holder base 10 has a top portion 12, a bottom portion 14, and a connector portion 16 interconnecting the top portion 12 and the bottom portion 14. The sample holding portion 20 is arranged in a space surrounded by the top portion 12, bottom portion 14, and connector portion 16. The top portion 12 is located on the more positive side of the sample holding portion 20 in the Z direction, while the bottom portion 14 is located on the more negative side of the sample holding portion 20 in the Z direction.

The sample holding portion 20 has a top portion 22, a bottom portion 24, and a connector portion 26 interconnecting the top portion 22 and the bottom portion 24. The sample 2 is placed in a space surrounded by the top portion 22, the bottom portion 24, and the connector portion 26. The top portion 22 is located on the more positive side of the sample 2 in the Z direction, while the bottom portion 24 is located on the more negative side of the sample 2 in the Z direction.

### 1.3. Sample Securing Portion

As shown in FIG. 5, the sample securing portion 30 has a sample stage 32 and a sample stage supporting member 34 providing support of the sample stage 32. The sample stage 32 is in contact with the surface of the sample 2 that faces the -Z direction, i.e., the bottom surface of the sample 2, and supports the sample 2. The sample stage 32 is connected to the front end of the sample stage supporting member 34. The sample stage supporting member 34 is a rodlike member. The sample stage 32 is connected to the front end of the sample stage supporting member 34. An external thread 35 is formed in the side surface of the stage support member 34.

In the sample securing portion 30, the sample 2 is pushed against the top portion 22 of the sample holding portion 20 by pushing up the sample stage 32 by the sample stage supporting member 34. Consequently, the sample 2 can be brought into intimate contact with the top portion 22 and thus the sample 2 can be secured to the sample holding portion 20. An internal thread 25 is formed in the bottom portion 24 of the sample holding portion 20, for example, as shown in FIG. 5. The sample stage supporting member 34 having the external thread 35 is inserted and tightened into the internal thread 25. Thus, the sample stage 32 pushes up the sample 2, whereby the sample 2 can be brought into intimate contact with the top portion 22.

The sample stage supporting member 34 is not in contact with the holder base 10. The bottom portion 14 of the holder base 10 is provided with a cutout 15. The sample stage supporting member 34 is connected to the sample holding portion 20 through the cutout 15.

FIG. 6 illustrates the operation of the sample securing portion 30. The sample stage supporting member 34 provides tiltable support of the sample stage 32, is cylindrical in shape, and has a circumferential side surface provided with a groove 37. The sample stage 32 has a recessed portion 33. The sample stage supporting member 34 has a front end portion 36 accommodated in the recessed portion 33. The opening of the recessed portion 33 has fringes 31 which protrude toward the groove 37. The front ends of the fringes 31 of the recessed portion 33 are located in the groove 37.

The fringes 31 of the opening of the recessed portion 33 are not in contact with the bottom of the groove 37. A gap G1 is formed between the fringes 31 and the bottom of the groove 37. Furthermore, the fringes 31 of the opening of the recessed portion 33 are not in contact with the front end portion 36, and another gap G2 is formed between the fringes 31 and the front end portion 36. Therefore, the sample stage 32 tilts according to the shape of the bottom surface of the sample 2. Thus, if the bottom surface of the sample 2 is tilted relative to the top surface of the sample 2 or if the bottom surface of the sample 2 is uneven, the top surface of the sample 2 can be brought into intimate contact with the top portion 22.

### 1.4. Positional Securing Portion

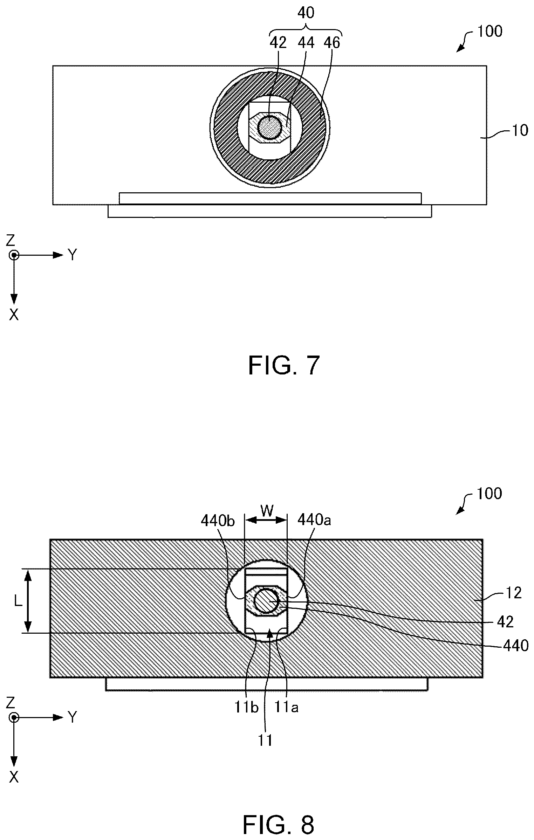

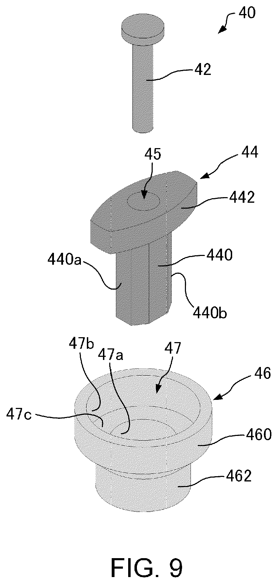

FIGS. 7 and 8 are schematic cross-sectional views of the sample holder 100. FIG. 7 is a cross-sectional view taken on line VII-VII of FIG. 4. FIG. 8 is a cross-sectional view taken on line VIII-VIII of FIG. 4. FIG. 9 is a schematic, exploded perspective view of the positional securing portion 40.

The positional securing portion 40 positionally secures the sample holding portion 20. As a result, the sample 2 is held in position. The positional securing portion 40 has a shaft 42, a first supportive member 44, and a second supportive member 46 as shown in FIGS. 4, 5, 7-9.

As shown in FIGS. 4 and 5, the front end of the shaft 42 is connected to the top portion 22 of the sample holding portion 20. The sample holding portion 20 is supported by the shaft 42.

The shaft 42 is rotatably supported by the first supportive member 44 and inserted in a hole 45 formed in the first supportive member 44. The rear end of the shaft 42 is greater in width or diameter than the hole 45. Therefore, the rear end of the shaft 42 is caught in the first supportive member 44, whereby the shaft 42 is supported.

The portion of the shaft 42 inserted in the hole 45 is smaller in diameter than the hole 45 and so the shaft 42 can rotate about its central axis. This permits the sample holding portion 20 to rotate about the shaft 42. The central axis of the shaft 42 is parallel to the Z axis.

The shaft 42 is rotatably supported by the first supportive member 44, which in turn has a shank portion 440 and a wider portion 442 that is greater in width than the shank portion 440. The shank portion 440 is inserted in an insertion hole 47 of the second supportive member 46.

As shown in FIG. 8, the holder base 10 is provided with a slot 11 extending through the top portion 12 of the holder base 10, as an example. The length L of the slot 11 taken along the X axis is greater than the width W taken along the Y axis. The shank portion 440 is inserted in the slot 11. The shank portion 440 has a first side surface 440a facing the +Y direction and a second side surface 440b facing the -Y direction. The first side surface 440a is in contact with a surface 11a of the base 10 which defines the width W of the slot 11. The second side surface 440b is in contact with a surface 11b of the base 10 which defines the width W of the slot 11. The surfaces 11a and 11b of the holder base 10 are opposite to each other and define the width W of the slot 11. That is, the distance between the surfaces 11a and 11b corresponds to the width W of the slot 11. The length L of the slot 11 is greater than the width of the shank portion 440 taken along the X axis.

In this way, rotation of the shank portion 440 is restricted by causing the first side surface 440a of the shank portion 440 to contact the surface 11a defining the width of the slot 11 and causing the second side surface 440b to contact the surface 11b defining the width of the slot 11. Therefore, if the second supportive member 46 is rotated, the first supportive member 44 does not rotate. Alternatively, the first side surface 440a of the shank portion 440 may be in contact with the surface 11a, but the second side surface 440b may not be in contact with the surface 11b in a manner not illustrated. Even in this case, rotation of the shank portion 440 can be restricted. Since the length L of the slot 11 is greater than the width of the shank portion 440 taken along the X axis, the first supportive member 44 can move along the X axis. That is, the first supportive member 44 can move along the X axis perpendicular to the axis of the shaft 42. If rotation of the shank portion 440 is restricted and the first supportive member 44 is movable along the X axis as described above, no restriction is imposed on the shape of the slot 11. For example, the length L of the slot 11 may be equal to or less than the width W of the slot 11 in a manner not shown.

As shown in FIGS. 4 and 5, the shank portion 440 of the first supportive member 44 is inserted in the insertion hole 47 of the second supportive member 46. The insertion hole 47 has both a first portion 47a in which the shank portion 440 is inserted and a second portion 47b greater in diameter than the first portion 47a. Because the first portion 47a and the second portion 47b of the insertion hole are different in diameter, a step 47c is formed between the first portion 47a and the second portion 47b. The wider portion 442 of the first supportive member 44 is caught on the step 47c lying between the first portion 47a and the second portion 47b of the hole. Consequently, the first supportive member 44 is so supported on the second supportive member 46 as to be movable along the X axis.

The second supportive member 46 supports the first supportive member 44 so that it can move along the X axis. The second supportive member 46 is provided with the insertion hole 47 in which the shank portion 440 of the first supportive member 44 is inserted. The second supportive member 46 has a knob 460 and a threaded shaft 462.

A first threaded portion 120 (e.g., an internally threaded portion) is formed in the top portion 12 of the holder base 10. The threaded portion 462 of the second supportive member 46 has a second threaded portion (such as an externally threaded portion) 463 which is threadably mounted in the first threaded portion 120. The second supportive member 46 having the second threaded portion 463 making threaded engagement with the first threaded portion 120 constitutes a feed screw for converting a rotary motion into a linear motion.

The second supportive member 46 is moved in the +Z direction, for example, by rotating the second supportive member 46 in a counterclockwise direction. As a result, the first supportive member 44 supported by the second supportive member 46 moves in the +Z direction and the shaft 42 supported by the first supportive member 44 also moves in the +Z direction. Therefore, the sample holding portion 20 connected to the shaft 42 can be moved in the +Z direction by rotating the second supportive member 46 counterclockwise. That is, the sample holding portion 20 connected to the second supportive member 46 via the first supportive member 44 and the shaft 46 can be pulled up by rotating the second supportive member 46 counterclockwise. Consequently, the sample holding portion 20 and the top portion 12 of the holder base 10 can be tightened together and thus the sample holding portion 20 can be secured.

On the other hand, when the knob 460 is rotated clockwise, the second supportive member 46 moves in the -Z direction. Consequently, the first supportive member 44 and the shaft 42 supported by the second supportive member 46 and the first supportive member 44, respectively, both move in the -Z direction. Therefore, by rotating the second supportive member 46 clockwise, the sample holding portion 20 connected to the shaft 42 can be moved in the -Z direction. That is, the tightening force between the holder base 10 and the sample holding portion 20 can be reduced or a gap can be formed between the base 10 and the sample holding portion 20 by rotating the second supportive member 46 clockwise. This permits translational and rotational motion of the sample holding portion 20.

No restrictions are imposed on the structure of the second supportive member 46 as long as any rotary motion can be transformed into a rectilinear motion. For example, the sample holding portion 20 may be pulled up by rotating the second supportive member 46 clockwise, and the tightening force between the holder base 10 and the sample holding portion 20 may be lowered by rotating the second supportive member 46 counterclockwise.

### 2. Operation of Sample Holder

### 2.1. Rotation of Sample Holding Portion

FIG. 10 illustrates the operation of the sample holder 100. In the sample holder 100, the sample holding portion 20 can be rotated about the shaft 42 as shown in FIG. 10. As described previously, the sample holding portion 20 is supported by the shaft 42, which in turn is rotatably supported to the first supportive member 44. Therefore, the sample holding portion 20 can rotate about the shaft 42. Consequently, the tilt θ of the sample 2 relative to the edge 51 of the shielding plate 50 can be adjusted.

### 2.2. Movement of the Sample Holding Portion along X Axis

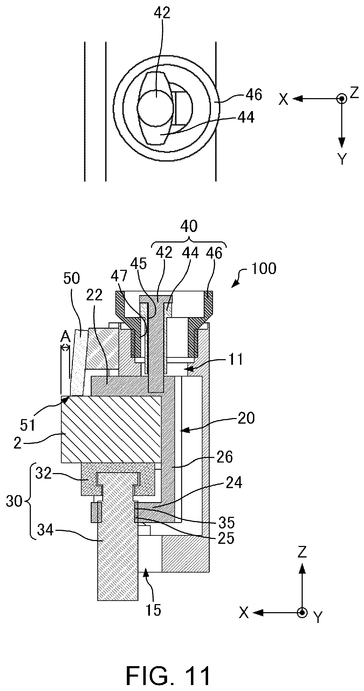

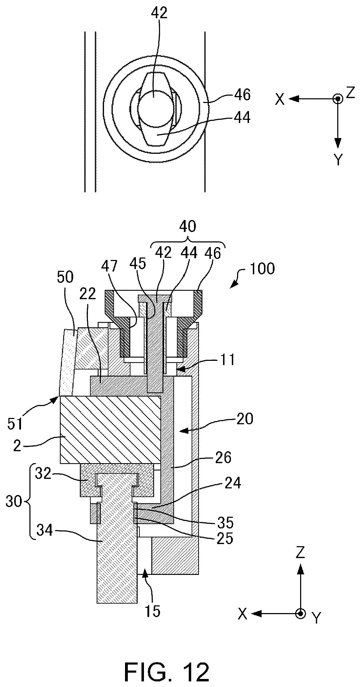

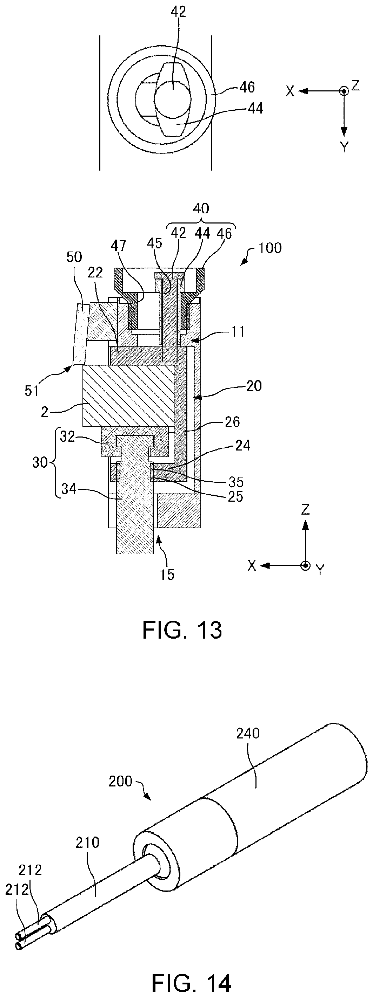

FIGS. 11-13 illustrate the operation of the sample holder 100. FIG. 11 illustrates a state in which the shank portion 440 of the first supportive member 44 is located at the end of the slot 11 as viewed in the +X direction. FIG. 12 illustrates a state in which the shank portion 440 is located at the center of the slot 11. FIG. 13 illustrates a state in which the shank portion 440 is at the end of the slot 11 as viewed in the -X direction.

The first supportive member 44 is supported to the second supportive member 46 so as to be movable along an axis perpendicular to the axis of the shaft 42, i.e., along the X axis. Therefore, as shown in FIGS. 11-13, the shaft 42 supported to the first supportive member 44, the sample holding portion 20 connected to the shaft 42, and the sample securing portion 30 can all move along the X axis. The amount of protrusion A of the sample 2 from the edge 51 of the shielding plate 50 secured to the holder base 10 can be adjusted by moving the sample holding portion 20 along the X axis.

The operation of the sample holder 100 as already illustrated in FIGS. 11-13 is performed while either lowering the tightening force applied between the holder base 10 and the sample holding portion 20 or forming a gap between the base 10 and the holding portion 20 and, at the same time, making the sample holding portion 20 translational and rotatable.

### 2.3. Securing of Sample Holding Portion

In the sample holder 100, the second supportive member 46 is moved in the +Z direction by rotating the knob 460 counterclockwise. This can pull up the sample holding portion 20 connected to the second supportive member 46 via both the first supportive member 44 and the shaft 42 and so the sample holding portion 20 and the top portion 12 of the holder base 10 can be tightened together. As a result, the sample holding portion 20 is secured.

Rotation of the first supportive member 44 is restricted because its shank portion 440 is inserted in the slot 11. Therefore, if the second supportive member 46 is rotated, the first supportive member 44 does not rotate concomitantly with the rotation of the second supportive member 46. Therefore, when the sample holding portion 20 and the holder base 10 are tightened together to secure the sample holding portion 20, it is assured that the sample holding portion 20 is secured firmly. As a result, positional deviation of the sample 2 when the sample holding portion 20 and the holder base 10 are tightened together can be reduced.

### 3. Tightening Tool

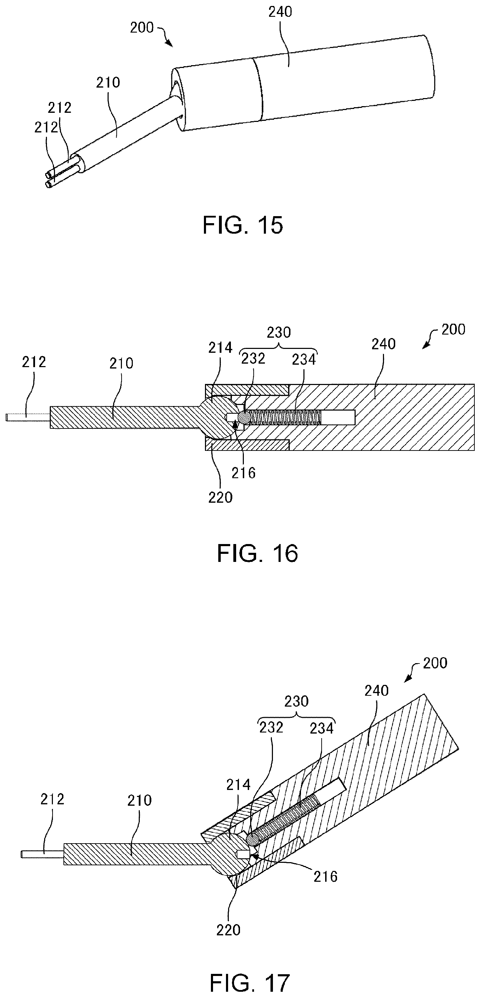

FIGS. 14 and 15 are schematic perspective views of a tightening tool 200. FIGS. 16 and 17 are schematic cross-sectional views of the tightening tool 200. FIGS. 14 and 16 illustrate a state in which the tightening tool 200 is not operative. FIGS. 15 and 17 illustrate a state in which the tightening tool 200 is operative. In the example of FIGS. 14 and 16, the tightening tool 200 is straightened as one example of inoperative state of the tightening tool 200. In the example of FIGS. 15 and 17, the tightening tool 200 is bent over as one example of operative state of the tightening tool 200.

The tightening tool 200 is used to tighten a fastener member such as a screw or a bolt. The sample holder 100 and the tightening tool 200 together constitute a sample holder set. In this sample holder set, the tightening tool 200 is used to tighten the second supportive member 46 that is a fastener member.

The tightening tool 200 is used to rotationally tighten the second supportive member 46 (knob 460) of the sample holder 100. By rotating the second supportive member 46 with the tightening tool 200, the second supportive member 46 can be tightened at less than a preset torque value. This can prevent application of any torque greater than the preset torque value to the second supportive member 46.

As shown in FIGS. 14-17, the tightening tool 200 includes a shank member 210, a shank support member 220, a positioning member 230, and a grip portion 240. The shank member 210 has a front end portion connected to the second supportive member 46. The shank member 210 has two pins 212 on the front end portion, the pins 212 being connected to the second support member 46. As long as the front end portion of the shank member 210 can be connected to the second support member 46, the front end portion may be configured dissimilarly from the two pins 212.

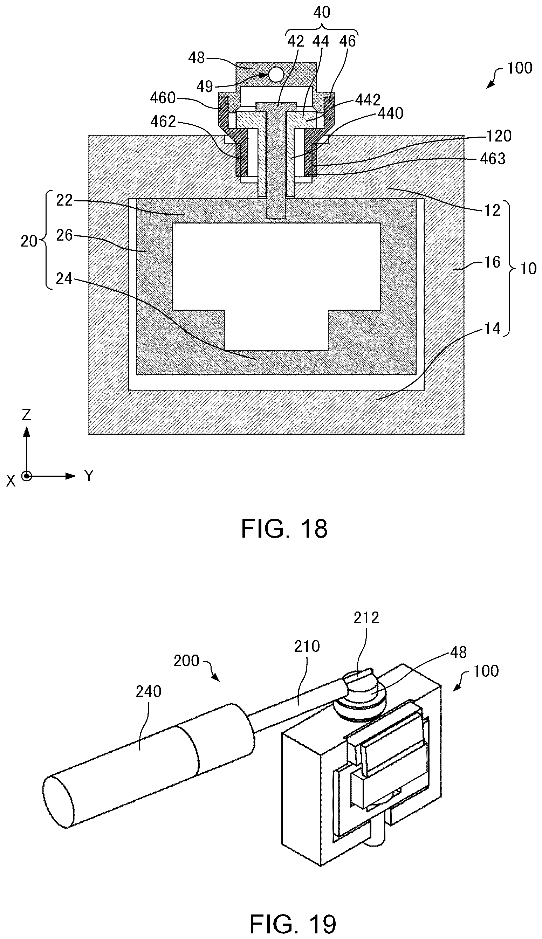

FIGS. 18 and 19 illustrate a cover member 48. As shown in these FIGS. 18 and 19, the second supportive member 46 has the cover member 48 which is mounted on the knob 460 of the second supportive member 46. The cover member 48 can be attached to and detached from the knob 460, for example. The knob 460 is rotated by rotating the cover member 48.

The cover member 48 is provided with a hole 49 for insertion of any one of the pins 212. One of the two pins 212 is inserted into the hole 49, while the other is placed on the cover member 48. By sandwiching the cover member 48 between the two pins 212, the sense (orientation) of insertion of the tightening tool 200 can be controlled. Therefore, the tilt of the tightening tool 200 can be controlled and thus can be connected to the second supportive member 46 horizontally or nearly horizontally. In this way, the posture of the tightening tool 200 can be controlled so as to assume a horizontal or nearly horizontal posture (i.e., the axis of the shank member 210 is horizontal) by sandwiching the cover member 48 between the two pins 212.

As shown in FIGS. 16 and 17, the shank member 210 has a rear end portion provided with a spherical or ball-like portion 214. The surface of the spherical portion 214 is spherical in shape, for example, at least partially. The spherical portion 214 is slidably supported by the shank support member 220. Therefore, the shank member 210 can rotate about the spherical portion 214. That is, the tightening tool 200 can be bent over in various directions. The shank support member 220 is formed, for example, at the front end of the grip portion 240 and constitutes a spherical bearing by which the spherical portion 214 is rotatably supported.

The spherical rear end portion 214 of the shank member 210 is provided with a recessed portion 216 that lies on an axis interconnecting the centers of the front and rear end portions of the shank member 210. This interconnecting axis is the central axis of the shank member 210.

The positioning member 230 is mounted in the grip portion 240 and includes a ball-like portion 232 fitted in the recessed portion 216 and a resilient member 234 for pushing the ball-like portion 232 against the recessed portion 216. The ball-like portion 232 is spherical in shape, for example. The surface of the ball-like portion 232 is spherical at least partially, for example. The diameter of the ball-like portion 232 is greater, for example, than the width of the recessed portion 216.

When the tightening tool 200 is straight as shown in FIGS. 14 and 16, the ball-like portion 232 is fitted in the recessed portion 216. When the tightening tool 200 is bent over as shown in FIGS. 15 and 17, the ball-like portion 232 is out of the recessed portion 216. The resilient member 234 pushes the ball-like portion 232 against the recessed portion 216. The torque value at which the tightening tool 200 is bent over can be set according to the magnitude of the force applied by the resilient member 234 to push the ball-like portion 232 against the recessed portion 216. For example, as the force applied by the resilient member 234 to push the ball-like portion 232 against the recessed portion 216 is increased, the torque value at which the tightening tool 200 is bent over is increased.

The resilient member 234 is a compression spring, for example. However, as long as the resilient member 234 is capable of pushing the ball-like portion 232 against the recessed portion 216, the resilient member 234 is not restricted to a compression spring. For example, the resilient member 234 may be a leaf spring. The ball-like portion 232 and the resilient member 234 together constitute a ball plunger, for example.

The grip portion 240 is a mechanical member that permits a user to grasp the tightening tool 200. The grip portion 240 is cylindrical in shape, for example. The shank support member 220 is mounted at an end of the grip portion 240. The shank member 210 extends from the end of the grip portion 240. When the tightening tool 200 is straight, the central axis of the shank member 210 and the central axis of the grip portion 240 are on the same straight line. When the tightening tool 200 is bent over, the central axis of the shank member 210 and the central axis of the grip portion 240 are not on the same straight line but intersect each other.

Under the condition where one of the pins 212 at the front end portion of the shank member 210 has been inserted in the hole 49 of the cover member 48 and the tightening tool 200 has been placed horizontally as shown in FIG. 19, the cover member 48 is rotated to tighten the second supportive member 46. Consequently, the positional securing portion 40 pulls up the sample holding portion 20, whereby the sample holding portion 20 can be tightened to the top portion 12 of the holder base 10.

If a torque greater than the preset torque value is applied to the second supportive member 46 at this time, the resilient member 234 pushes the ball-like portion 232 against the recessed portion 216, applying a force greater than to maintain the posture of the shank member 210 to the shank member 210. This brings the ball-like portion 232 out of the recessed portion 216 as shown in FIGS. 15 and 17. As a result, the tightening tool 200 is bent over. Accordingly, any torque greater than the preset torque value can be prevented from being applied to the second supportive member 46 by tightening in the second supportive member 46 with the tightening tool 200 until the tightening tool 200 is bent over.

The spherical portion 214 of the rear end portion of the shank member 210 is supported by the shank support member 220 which provides rotatable support of the spherical portion 214. Therefore, if a force greater than the given force is applied to the shank member 210, the ball-like portion 232 disengages from the recessed portion 216, irrespective of the direction of the force applied to the shank member 210. Accordingly, if a force exceeding the preset force is applied to the shank member 210, the tightening tool 200 is bent over, irrespective of the direction of the force applied to the shank member 210. Consequently, it can be prevented with greater certainty that a torque higher than the preset torque value is applied to the second supportive member 46. For example, if a great force is applied to the shank member 210 from an unintended direction, the tightening tool 200 is bent over. Therefore, it can be prevented more certainly that a torque greater than the preset torque value is applied to the second supportive member 46.

The positional deviation of the sample holding portion 20 can be reduced by tightening the second supportive member 46 at less than the preset torque value by the use of the tightening tool 200. For example, when the sample holding portion 20 and the holder base 10 are tightened together, if an excessive torque is applied to the second supportive member 46, distortions are induced in the sample holding portion 20, the holder base 10, and the positional securing portion 40 that comprises the shaft 42, the first supportive member 44, and the second supportive member 46. As a result, the sample holding portion 20 may produce a positional deviation. By tightening the second supportive member 46 using the tightening tool 200, it can be prevented that a torque greater than the preset torque value is applied to the second supportive member 46. This produces less distortions in the sample holding portion 20, the holder base 10, and the positional securing portion 40. As a consequence, the positional deviation of the sample holding portion 20 can be reduced.

The force applied by the resilient member 234 to push the ball-like portion 232 against the recessed portion 216 can be made variable. In this case, the torque value at which the tightening tool 200 is bent over can be made variable. For example, a compression mechanism for compressing the compression spring constituting the resilient member 234 may be provided in a manner not illustrated. Consequently, the amount of compression of the compression spring can be adjusted, and the force of the compression spring can be made variable. That is, the force applied by the resilient member 234 to push the ball-like portion 232 against the recessed portion 216 can be made variable. This allows for adjustment of the torque value at which the tightening tool 200 is bent over. The compression mechanism may be a screw mounted, for example, behind the resilient member 234. With this compression mechanism, the amount of compression of the compression spring can be adjusted by the degree to which the screw is tightened.

### 4. Sample Milling Equipment

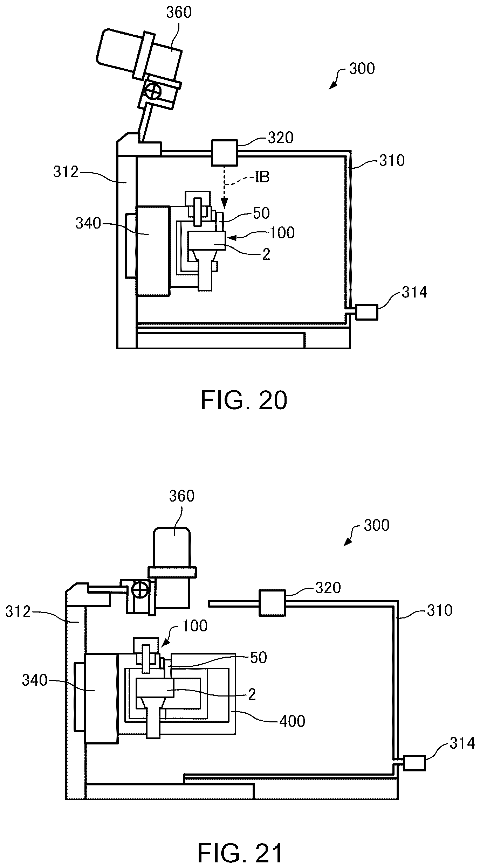

FIG. 20 shows one example of configuration of sample milling equipment 300 which is an ion beam milling apparatus for preparing a sample for observation or analysis by irradiating the sample 2 with an ion beam IB to mill the sample 2. The sample milling equipment 300 can mill a cross section through the sample 2, for example.

The sample milling equipment 300 is used to prepare a sample for electron microscopy, for example, such as scanning electron microscopy (SEM), transmission electron microscopy (TEM), or scanning transmission electron microscopy (STEM). Also, the sample milling equipment 300 is used to prepare a sample for an electron probe microanalyzer (EPMA) or an Auger microprobe.

As shown in FIG. 20, the sample milling equipment 300 includes the sample holder 100. Furthermore, the milling equipment 300 includes a vacuum chamber 310, a sample stage extracting mechanism 312, a vacuum pumping system 314, an ion source 320, a sample stage 340, and a positioning camera 360.

Within the vacuum chamber 310, the ion beam IB is directed at the sample 2. The interior of the vacuum chamber 310 is evacuated to a vacuum by the vacuum pumping system 314. The sample stage extracting mechanism 312 is used to extract the sample stage 340 from inside the vacuum chamber 310. The extracting mechanism 312 is mounted to the vacuum chamber 310 in an openable and closable manner so as to plug up the opening of the chamber 310. The sample stage 340 is mounted to the sample stage extracting mechanism 312.

The ion source 320 which emits the ion beam IB at the sample 2 as described above is mounted in the vacuum chamber 310. The ion source 320 is an ion gun which emits the ion beam IB by accelerating the beam at a given accelerating voltage. For example, the ion source 320 emits the ion beam IB by ionizing Ar gas. The diameter of the ion beam IB is on the order of 1 to 2 mm, for example.

The sample holder 100 is detachably mounted on the sample stage 340 and holds the sample 2. The sample holder 100 is equipped with the shielding plate 50 that is placed on the sample 2 to block the ion beam IB. In the sample milling equipment 300, the ion beam IB hits the portion of the sample 2 protruding from the shielding plate 50. Consequently, a cross section through the sample 2 can be milled.

The sample stage 340 provides swingable or rotatable support of the sample holder 100. Therefore, the sample 2 can be irradiated with the ion beam IB while swinging or rotating the sample 2. The sample stage 340 is equipped with a cooling mechanism for cooling the sample holder 100, for example, in order to reduce the ion beam milling damage to the sample 2.

The positioning camera 360 is mounted on top of the sample stage extracting mechanism 312. The camera 360 is mounted to an optical microscope, for example.

FIG. 21 illustrates the operation of the sample stage extracting mechanism 312, and shows a state in which the extracting mechanism 312 is open.

When the sample stage extracting mechanism 312 is open as shown in FIG. 21, if a target milling position on the sample 2 is aligned with the field of view of the positioning camera 360, the ion beam IB emitted from the ion source 320 strikes the target milling position while the sample stage extracting mechanism 312 is closed as shown in FIG. 20. In this way, with the sample milling equipment 300, the ion beam IB can be made to strike the target milling position on the sample 2 by adjusting the position of the sample 2 using the positioning camera 360.

With the sample milling equipment 300, the sample 2 can be placed in position relative to the shielding plate 50 by the use of both the positioning camera 360 and a sample position adjusting jig 400. The jig 400 will be described in detail later.

### 5. Jig for Positional Adjustment of Sample

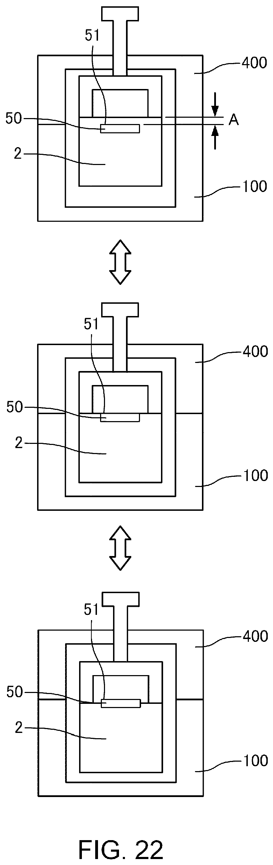

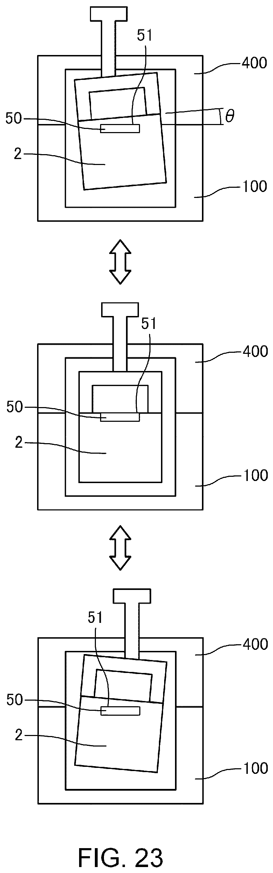

FIGS. 22 and 23 illustrate the jig 400 for positional adjustment of the sample. In these FIGS. 22 and 23, the sample holder 100 and the jig 400 for positional adjustment of the sample are shown in simplified form.

With the sample holder 100, the sample 2 is placed in position relative to the shielding plate 50 by the use of the sample position adjusting jig 400. The jig 400 is mounted on the sample holder 100 as shown in FIGS. 22 and 23.

When the amount of protrusion A of the sample 2 from the edge 51 of the shielding plate 50 is adjusted, the sample holding portion 20 is pushed in or extracted using the adjusting jig 400 as shown in FIG. 22. The sample holding portion 20 can move along the X axis as shown in FIGS. 11-13. Therefore, by pushing in or extracting the sample holding portion 20 using the adjusting jig 400, the amount of protrusion A can be adjusted.

When the tilt θ of the sample 2 relative to the edge 51 of the shielding plate 50 is adjusted, either the edge of the sample holding portion 20 as viewed in the + Y direction or the edge of the sample holding portion 20 as viewed in the -Y direction is pushed using the adjusting jig 400 as shown in FIG. 23. As shown in FIG. 10, the sample holding portion 20 can rotate about the shaft 42. Therefore, the tilt θ can be adjusted by pushing the edge of the sample holding portion 20 as viewed in the +Y direction or the edge of the sample holding portion 20 as viewed in the -Y direction using the adjusting jig 400.

### 6. Sample Milling Method

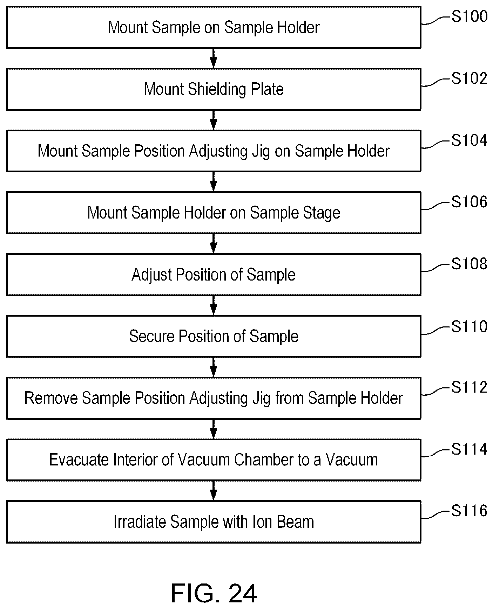

FIG. 24 is a flowchart illustrating one example of sample milling method using the sample milling equipment 300.

First, as shown in FIGS. 1 and 3-5, the sample 2 is mounted on the sample holder 100 (step S100).

The sample 2 is secured to the sample holding portion 20 using the sample securing portion 30. In particular, the sample stage 32 is pushed up by the sample stage supporting member 34 by tightening the supporting member 34 formed with the external thread 35 as shown in FIG. 5 to push the sample 2 against the top portion 22 of the sample holding portion 20. Consequently, the sample 2 can be secured to the sample holding portion 20.

In this way, a surface contact can be provided between the sample 2 and the sample holding surface 20 by pushing the sample 2 against the sample holding portion 20 so that the sample 2 is brought into intimate contact with the sample holding portion 20. Consequently, in the sample stage 340 provided with the cooling mechanism, the sample 2 can be cooled at enhanced efficiency.

Then, the shielding plate 50 is attached to the shielding plate holding member 60 (step S102). At this time, the shielding plate 50 is pushed against the top surface of the sample 2.

Then, as shown in FIG. 21, the jig 400 for positional adjustment of the sample is mounted on the sample holder 100 (step S104). The sample holder 100 is mounted on the sample stage 340 (step S106).

The sample stage extracting mechanism 312 is opened, and the sample holder 100 on which the jig 400 for positional adjustment of the sample has been mounted is mounted on the sample stage 340.

Then, the position of the sample 2 is adjusted (step S108).

In the step S108 of adjusting the position of the sample 2, the amount of protrusion A of the sample 2 from the edge 51 of the shielding plate 50 and the tilt θ of the sample 2 relative to the edge 51 of the shielding plate 50 are adjusted. More specifically, the amount of protrusion A is adjusted by pushing in or extracting the sample holding portion 20 using the adjusting jig 400 as shown in FIG. 22 while checking the positional relationship between the shielding plate 50 and the sample 2 with the positioning camera 360. The tilt θ of the sample 2 is adjusted by pushing either the edge of the sample holding portion 20 as viewed in the +Y direction or the edge of the sample holding portion 20 as viewed in the -Y direction by the use of the jig 400 as shown in FIG. 23 while checking the positional relationship between the shielding plate 50 and the sample 2 with the positioning camera 360.

Then, the second supportive member 46 is tightened with the tightening tool 200 to tighten together the sample holding portion 20 and the holder base 10, and the position of the sample 2 is secured (step S110).

First, as shown in FIGS. 18 and 19, one of the two pins 212 is inserted into the hole 49 in the cover member 48, and the tightening tool 200 is placed horizontally. Then, the cover member 48 is rotated with the tightening tool 200 to tighten the second supportive member 46. The tightening is ended when the tightening tool 200 is bent over. Consequently, the sample holding portion 20 and the holder base 10 can be tightened together. As a result, the position of the sample holding portion 20, i.e., the position of the sample 2, is fixed. The use of the tightening tool 200 makes it possible to tighten the second supportive member 46 at less than the preset torque value. Hence, the positional deviation of the sample 2 can be reduced.

Because the tightening tool 200 can have access to the sample holder 100 from a horizontal direction, even if the space above the sample holder 100 is small, easy access to the sample holder 100 is provided.

Then, as shown in FIG. 20, the tightening tool 200 and the adjusting jig 400 are removed from the sample holder 100 (step S112). The sample stage extracting mechanism 312 is closed, and the interior of the vacuum chamber 310 is evacuated to a vacuum by the vacuum pumping system 314 (step S114). After the interior of the vacuum chamber 310 reaches a target degree of vacuum, the sample 2 held on the sample holder 100 is irradiated with the ion beam IB, thus milling the sample 2 (step S116). Because of the processing steps described so far, the sample 2 can be milled with the ion beam IB.

### 7. Advantageous Effects

The sample holder 100 is for use with the sample milling equipment which mills the sample 2 by irradiating it with the ion beam. The sample holder 100 includes the holder base 10, the sample holding portion 20 for holding the sample 2, and the positional securing portion 40 for securing the position of the sample holding portion 20. The positional securing portion 40 includes the shaft 42 connected to the sample holding portion 20, the first supportive member 44 providing rotatable support of the shaft 42, and the second supportive member 46 supporting the first supportive member 44 so as to be movable along an axis perpendicular to the axis of the shaft 42. By rotating the second supportive member 46, it is moved along the axis of the shaft 42, thus tightening together the sample holding portion 20 and the holder base 10. This restricts rotation of the first supportive member 44 concomitant with the rotation of the second supportive member 46.

With the sample holder 100, when the second supportive member 46 is rotated to tighten together the sample holding portion 20 and the holder base 10, the first supportive member 44 does not rotate concomitantly with the rotation of the second supportive member 46. Accordingly, with the sample holder 100, the positional deviation of the sample 2 when the sample holding portion 20 and the holder base 10 are tightened together can be reduced. As a consequence, a cross section at a target position on a sample, for example, having a fine pattern can be formed.

In the sample holder 100, the first threaded portion 120 is formed in the holder base 10. The second threaded portion 463 that makes a threaded engagement with the first threaded portion 120 is formed in the second supportive member 46. Therefore, with the sample holder 100, the sample holding member 20 and the holder base 10 can be tightened together by tightening the second supportive member 46.

In the sample holder 100, the positional securing portion 40 tightens together the sample holding portion 20 and the holder base 10 by rotating the second supportive member 46 and pulling up the sample holding portion 20. With the sample holder 100, the sample 2 and the shielding plate 50 can be brought into intimate contact with each other because the sample 2 comes closer to the shielding plate 50 when the sample holding portion 20 is pulled up.

In the sample holder 100, the holder base 10 is provided with the slot 11 formed along the X axis that is perpendicular to the shaft 42. The first supportive member 44 has the shank portion 440 inserted in the slot 11. The shank portion 440 has the first side surface 440a that makes contact with the surface 11a defining the width W of the slot 11. Therefore, the sample holder 100 can restrict rotation of the first supportive member 44 concomitant with the rotation of the second supportive member 46.

In the sample holder 100, the first supportive member 44 has the wider portion 442 greater in width than the shank portion 440. The second supportive member 46 is provided with the insertion hole 47 in which the first supportive member 44 is inserted. The insertion hole 47 has the first portion 47a in which the shank portion 440 is inserted and the second portion 47b greater in diameter than the first portion 47a. The wider portion 442 is caught on the step portion 47c between the first portion 47a and the second portion 47b. Therefore, in the sample holder 100, the first supportive member 44 can move along the X axis, and can move along the Z axis concomitantly with movement of the second supportive member 46 along the Z axis.

The sample holder 100 includes the shielding plate 50 that shields a part of the sample 2. Therefore, the sample holder 100 can be used as a sample holder designed to mill cross sections.

The sample holder 100 includes the sample securing portion 30 for securing the sample 2 to the sample holding portion 20. The sample securing portion 30 has the sample stage 32 making contact with the sample 2 and the sample stage supporting member 34 providing tiltable support of the sample stage 32. Therefore, with the sample holder 100, if the bottom surface of the sample 2 is tilted relative to the top surface of the sample 2 or if the bottom surface of the sample 2 is uneven, the top surface of the sample 2 can be brought into intimate contact with the top portion 22 of the sample holding portion 20.

The sample holder set includes the sample holder 100 and the tightening tool 200 for tightening the second supportive member 46 at less than the preset torque value. Therefore, in the sample holder set, if the second supportive member 46 is tightened, less distortions are induced in the holder base 10, sample holding portion 20, and positional securing portion 40. Consequently, the positional deviation of the sample 2 can be reduced.

For example, if a user directly tightens the second supportive member 46, an excessive torque will be applied to the second supportive member 46. This may produce greater distortions in the holder base 10, sample holding portion 20, and positional securing portion 40. As a result, the position of the sample 2 may deviate. Application of an excessive torque to the second supportive member 46 can be prevented by tightening the second supportive member 46 using the tightening tool 200. This can reduce the distortions in the holder base 10, sample holding portion 20, and positional securing portion 40. Consequently, the use of the tightening tool 200 can reduce the positional deviation of the sample 2 when the holder base 10 and the sample holding portion 20 are tightened together.

The tightening tool 200 includes: the shank member 210 whose front end portion can be connected to the second supportive member 46; the shank support member 220 providing rotatable support of the rear end portion of the shank member 210; and the positioning member 230 for placing the shank member 210 in position. The shank member 210 has the rear end portion provided with the recessed portion 216. The positioning member 230 includes the ball-like portion 232 fitted in the recessed portion 216 and the resilient member 234 for pushing the ball-like portion 232 against the recessed portion 216. When a torque greater than the preset torque value is applied to the second supportive member 46, the ball-like portion 232 comes out of the recessed portion 216. Therefore, with the tightening tool 200, if a torque greater than the given torque value is applied to the second supportive member 46, the tightening tool 200 is bent over. Consequently, the tightening tool 200 permits the second supportive member 46 to be tightened at less than the preset torque value and thus the positional deviation of the sample 2 can be reduced.

In the tightening tool 200, the spherical portion 214 is formed on the rear end portion of the shank member 210. The recessed portion 216 is formed on the axis interconnecting the center of the spherical portion 214 and the front end portion. Therefore, with the tightening tool 200, if an excessive force is applied to the shank member 210, the ball-like portion 232 comes out of the recessed portion 216 irrespective of the direction of the force applied to the shank member 210. In this case, the tightening tool 200 is bent over. Therefore, it can be prevented with greater certainty that a torque greater than the preset torque value is applied to the second supportive member 46.

In the tightening tool 200, the force applied by the resilient member 234 to push the ball-like portion 232 against the recessed portion 216 is variable. This allows for adjustment of the torque at which the second supportive member 46 is tightened with the tightening tool 200.

Because the sample milling equipment 300 includes the sample holder 100, the positional deviation of the sample 2 when it is secured can be reduced and so precise milling can be done at the target milling position.

### 8. Modifications

It is to be understood that the present invention is not restricted by the above-described embodiments and that the invention can be implemented in variously modified forms without departing from the gist of the invention.

### 8.1. First Modification

In the above-described embodiment, as shown in FIG. 21, the sample holder 100 is mounted on the sample stage 340 of the sample milling equipment 300, and the sample 2 is placed in position relative to the shielding plate 50. Alternatively, before the sample holder 100 is mounted on the sample stage 340, the sample 2 may be placed in position relative to the shielding plate 50. For example, the sample 2 may be placed in position using an optical microscope. In particular, after the sample 2 is placed in position with the optical microscope, the position of the sample holding portion 20 is fixed using the tightening tool 200. Then, the sample holder 100 may be mounted on the sample stage 340 of the sample milling equipment 300.

### 8.2. Second Modification

In the above-described embodiment, as shown in FIG. 20, after removing the jig 400 for positional adjustment of the sample, the sample 2 held on the sample holder 100 is irradiated with the ion beam IB to mill the sample 2. Alternatively, the sample 2 may be irradiated with the ion beam IB to mill the sample 2 while the jig 400 is mounted on the sample holder 100 in a manner not illustrated. For example, the front end portion of the shank member 210 of the tightening tool 200 may be secured to the second supportive member 46 of the sample holder 100.

### 8.3. Third Modification

In the above-described embodiment, the second supportive member 46 is tightened using the tightening tool 200 which is bent over when a torque greater than the given torque value is applied to the second supportive member 46. When the second supportive member 46 is tightened, it is not necessary to use the tightening tool 200. For example, the second supportive member 46 may be tightened using a tool which will be broken when a torque greater than the given torque value is applied to the second supportive member 46. Examples of such a tool include wooden rods and resinous rods. The torque value at which the rod is broken may be set, for example, by adjusting the thickness or material of the rod.

The same advantageous effects can be produced as when the tightening tool 200 is used by tightening the second supportive member 46 using a tool which will be broken when a torque greater than a given torque value is applied to the second supportive member 46. This tool may be disposable.

### 8.4. Fourth Modification

In the above embodiment, as shown in FIGS. 18 and 19, the tightening tool 200 is connected to the cover member 48 of the second supportive member 46. Alternatively, the cover member 48 may not be used. A hole into which one of the pins 212 is inserted may be formed in the knob 460 of the second supportive member 46. The tightening tool 200 may be connected to this second supportive member 46.

### 8.5. Fifth Modification

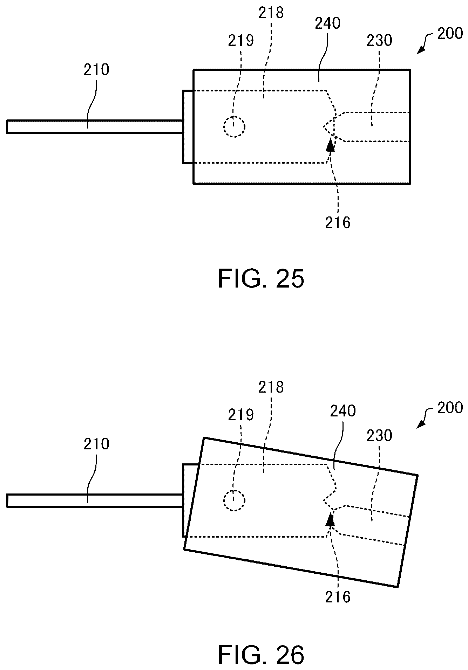

FIGS. 25 and 26 show a modification of the tightening tool 200. FIG. 25 shows a state in which the tightening tool 200 is straight. FIG. 26 shows a state in which the tightening tool 200 has been bent over.

As shown in FIGS. 25 and 26, the tightening tool 200 includes the shank member 210, the positioning member 230, and the grip portion 240.

In the tightening tool 200, the positioning member 230 is a leaf spring. The torque value at which the tightening tool 200 is bent over can be set using the spring force of the leaf spring. A rotary portion 218 capable of rotating about an axis of rotation 219 is mounted in the rear end portion of the shank member 210. The rotary portion 218 is provided with the recessed portion 216 lying on an axis interconnecting the front end portion of the shank member 210 and the axis of rotation 219.

When the tightening tool 200 is straight as shown in FIG. 25, the leaf spring serving as the positioning member 230 is fitted in the recessed portion 216. When a torque greater than the given torque value is applied to the second supportive member 46, the leaf spring comes out of the recessed portion 216 as shown in FIG. 26. Consequently, the tightening tool 200 is bent over.

The tightening tool 200 shown in FIGS. 25 and 26 can prevent application of a torque greater than the given torque value to the second supportive member 46 in the same manner as the tightening tool 200 shown in FIGS. 14-17.

In the above-described tightening tool 200 shown in FIGS. 14-17, the spherical portion 214 in the rear end portion of the shank member 210 is supported by the shank support member 220 that provides rotatable support of the spherical portion 214 and so the tightening tool 200 is bent over in various directions. However, the tightening tool 200 shown in FIGS. 25 and 26 are bent over about the single axis 219. That is, there is only one axis of bend. The tightening tool 200 may also have a plurality of axes of bend (not shown).

### 8.6. Sixth Modification

In the above-described embodiment, as shown in FIGS. 22 and 23, the position of the sample 2 relative to the shielding plate 50 is adjusted using the jig 400 for positional adjustment of the sample. Alternatively, the position of the sample 2 may be adjusted without using the jig 400 by moving the sample holding portion 20 with tweezers or the like.

It is to be noted that the above embodiments and modifications are merely exemplary and that the present invention are not restricted thereto. For example, the embodiments and modifications may be combined appropriately.

It is to be understood that the present invention is not restricted to the above-described embodiments but can be implemented in variously modified forms. For example, the present invention embraces configurations (e.g., configurations identical in function and method) which are substantially identical to the configurations described in any one of the above embodiments. Furthermore, the invention embraces configurations which are similar to the configurations described in any one of the above embodiments except that their nonessential portions have been replaced. Further, the invention embraces configurations which are similar to the configurations described in any one of the above embodiments except that a well-known technique is added.

## Claims

1. A sample holder for use in sample milling equipment that mills a sample by irradiating it with an ion beam, said sample holder comprising:
a holder base;
a sample holding portion for holding the sample; and
a positional securing portion for securing the sample holding portion in position;
wherein said positional securing portion includes a shaft connected to the sample holding portion and having an axis, a first supportive member providing rotatable support of the shaft, and a second supportive member supporting the first supportive member such that the first supportive member can move along an axis perpendicular to the axis of the shaft; and
wherein when the second supportive member is rotated, it moves along the axis of the shaft, thus tightening together the sample holding portion and the holder base, while rotation of the first supportive member concomitant with the rotation of the second supportive member is restricted.

2. A sample holder as set forth in claim 1, wherein said holder base is provided with a first threaded portion, and wherein said second supportive member is provided with a second threaded portion that makes threaded engagement with the first threaded portion.

3. A sample holder as set forth in claim 1 or 2, wherein said position securing portion tightens together said sample holding portion and said holder base by rotating said second supportive member and pulling up the sample holding portion.

4. A sample holder as set forth in any preceding claim, wherein said holder base is provided with a slot formed along said perpendicular axis, and wherein said first supportive member has a shank portion inserted in the slot, the shank portion having a surface making a contact with a surface of the holder base which defines the width of the slot.

5. A sample holder as set forth in claim 4,
wherein said first supportive member has a wider portion that is greater in width than said shank portion;
wherein said second supportive member is provided with an insertion hole in which the first supportive member is inserted;
wherein the insertion hole has a first portion and a second portion greater in diameter than the first portion, the shank portion being inserted in the first portion; and
wherein the wider portion is caught on a step between the first and second portions.

6. A sample holder as set forth in any preceding claim, further comprising a shielding plate that shields a part of said sample.

7. A sample holder as set forth in any preceding claim, further comprising a sample securing portion for securing said sample to said sample holding portion, and wherein the sample securing portion has a sample stage and a sample stage supporting member providing tiltable support of the sample stage that makes contact with the sample.

8. A sample holder set comprising:
a sample holder as set forth in any one of claims 1 to 7; and
a tightening tool for tightening said second supportive member of said positional securing portion at less than a given torque value.

9. A sample holder set as set forth in claim 8,
wherein said tightening tool includes a shank member having a front end portion connectable to said second supportive member, a shank support member providing rotatable support of a rear end portion of the shank member, and a positioning member for placing the shank member in position, the rear end portion of the shank member being provided with a recessed portion;
wherein the positioning member includes a ball-like portion fitted in the recessed portion and a resilient member for pushing the ball-like portion against the recessed portion; and
wherein when a torque greater than the given torque value is applied to the second supportive member, the ball-like portion comes out of the recessed portion.

10. A sample holder set as set forth in claim 9, wherein a spherical portion is formed in the rear end portion of said shank member, and wherein said recessed portion is formed on an axis interconnecting a center of the spherical portion and said front end portion.

11. A sample holder set as set forth in claim 9 or 10, wherein said resilient member applies a variable force to said ball-like portion to push it against said recessed portion.

12. Sample milling equipment including a sample holder as set forth in any one of claims 1 to 7.

13. A tightening tool for tightening a fastener member, comprising:
a shank member having a front end portion connected to the fastener member;
a shank support member providing rotatable support of a rear end portion of the shank member, the rear end portion being provided with a recessed portion; and
a positioning member for placing the shank member in position;
wherein the positioning member includes a ball-like portion fitted in the recessed portion and a resilient member for pushing the ball-like portion against the recessed portion; and
wherein when a torque greater than a given torque value is applied to the fastener member, the ball-like portion comes out of the recessed portion.
